# FASCICULE DE BREVET EUROPEEN

(11) **EP 1 149 329 B1**
(45) Date de publication et mention de la délivrance du brevet: **14.05.2003**
(21) Numéro de dépôt: 00901679.1
(22) Date de dépôt: 28.01.2000
(51) Int. Cl.: G03F 9/00, B01L 3/02, G02B 27/58, G02B 7/00

(54) **DISPOSITIF D'ALIGNEMENT POUR L'ASSEMBLAGE DE MICROSYSTEMES**
AUSRICHTVORRICHTUNG FÜR ZUSAMMENSETZUNG VON MIKROSYSTEMEN
ALIGNING DEVICE FOR ASSEMBLING MICROSYSTEMS

(30) Priorité: 03.02.1999 FR 9901415
(43) Date de publication de la demande: 31.10.2001
(73) Titulaire: Optique et Microsystemes S.A., 01130 Le Poizat (FR)
(72) Inventeur: BURRY, Jean-Michel, F-01130 Lalleyriat (FR)
(74) Mandataire: Gasquet, Denis
(86) Numéro de dépôt international: FR0000212
(87) Numéro de publication internationale: WO00046642

(56) Documents cités:
- FR-A- 2 720 523
- US-A- 3 694 091
- US-A- 4 398 824
- US-A- 4 521 114

## Description

### Domaine technique de l'invention

La présente invention concerne un dispositif destiné à la visualisation, en vue de l'alignement et du positionnement relatif de dispositifs micro mécaniques, micro optiques, micro électroniques ( puces ), opto électroniques ( diodes laser, photodiodes ), ou autres, par la méthode de retournement de composant ( alignement de deux faces en regard ). Le procédé d'assemblage est schématisé dans les figures (1a) et (1b)

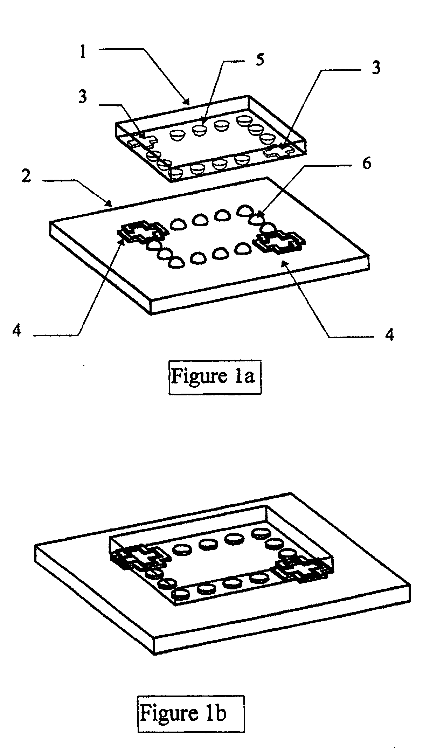

En référence à la figure 1a, la méthode de report de composants considérée consiste à déposer de manière précise un ou plusieurs composants (1) sur un substrat (2). En règle générale, le composant (1) et le substrat (2) ne sont pas transparents. Pour assurer la précision de dépose des repères d'alignement (3) et (4) peuvent être respectivement tracés sur la face inférieure du composant (1) et la face supérieure du substrat (2). L'assemblage final du dispositif peut être réalisé par collage, soudure ou adhérence naturelle grâce à la présence éventuelle de plots (5) et (6) de soudure ou de colle présents respectivement sur le composant (1) et/ou le substrat (2). Toute autre méthode d'assemblage peut s'envisager. Cet assemblage final constitue un nouveau composant hybride figure 1b.

### Etat des techniques antérieures

Lors de l'assemblage de petits composants (taille de l'ordre de 0.2mm à 5mm), pour lesquels une grande précision de positionnement est requise (de l'ordre de 0.5µm à quelques µm), plusieurs types de méthodes sont habituellement utilisées.

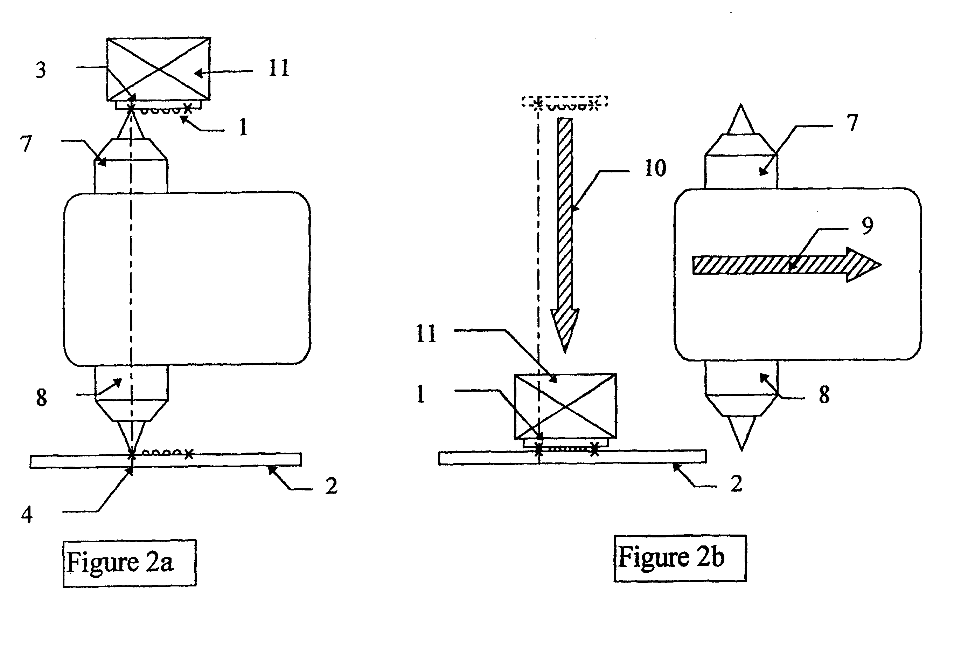

La figure 2a et la figure 2b illustrent une méthode, qui consiste à utiliser un système de visée double comportant deux objectifs de microscopes (7) et (8), l'un visant la face inférieure du composant (1), l'autre visant la face supérieure du substrat (2). Ces microscopes permettent de visualiser les motifs d'alignement (3) et (4) et de corriger les défauts de positionnement. Après correction, un mouvement d'escamotage (9) est appliqué système de visée, puis un déplacement programmé (10) est appliqué au composant (1) par l'intermédiaire d'un dispositif mécanique (11) pour le déposer sur le substrat (2). Cette méthode pose les problèmes techniques suivants :
■ Utilisation de deux systèmes de visée microscopiques devant avoir exactement les mêmes caractéristiques (appairage).
■ Obligation d'escamoter les microscopes avant dépose du composant
■ Trajet de dépose de composant important, nuisible à de grandes cadences de production.

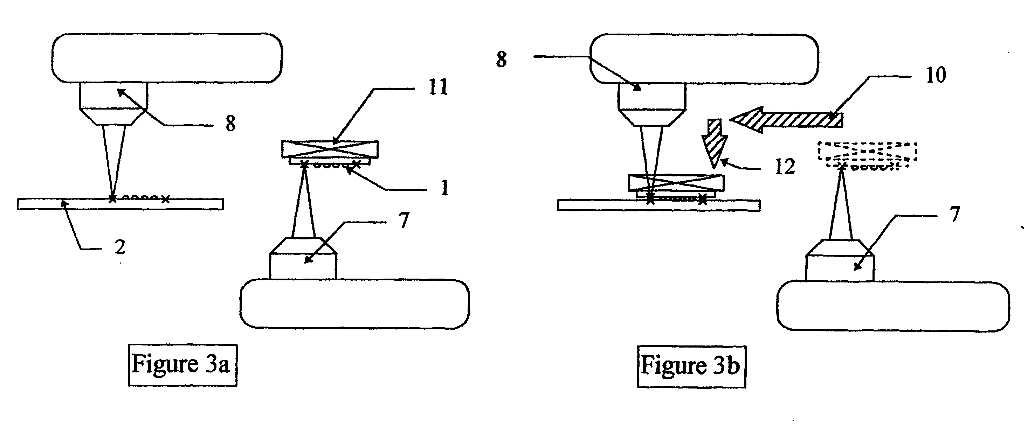

La figure 3a et la figure 3b illustrent une variante de la méthode précédente, utilisant deux microscopes (7) et (8) fixes, et appliquant deux déplacements (10) et (12) au composant (1).

Cette méthode pose les problèmes techniques suivants :
■ Utilisation de deux systèmes de visée microscopiques devant avoir exactement les mêmes caractéristiques (appairage).
■ Deux trajets de dépose de composant importants, nuisibles à de grandes cadences de production.
■ Nécessité pour le déplacement horizontal (10) d'une grande précision absolue.

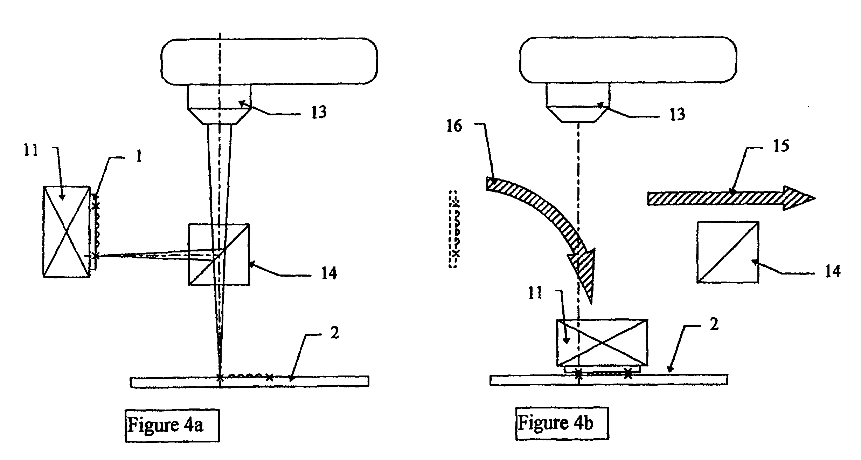

La figure 4a et la figure 4b illustrent une méthode utilisant un seul système de visée microscopique (13) et un cube séparateur de faisceaux (14) permettant de superposer les images du composant (1) et du substrat (2) lors de la phase d'alignement. Après alignement, un mouvement d'escamotage (15) du cube séparateur (14) et un mouvement de basculement (16) du support (11) de composant (1) sont effectués pour déposer le composant (1) sur le substrat (2). Cette méthode pose les problèmes techniques suivants :
■ La position finale du composant est sensible à l'épaisseur du composant ( un composant trop mince entraînera un basculement trop important, et un composant trop épais entraînera un basculement trop faible).
■ Obligation d'escamoter le prisme avant dépose du composant.
■ Distance de visée importante, généralement incompatible avec l'utilisation de microscopes à forte résolution et à forts grandissements.
■ Visée à travers un importante épaisseur de verre, généralement nuisible avec l'utilisation de microscopes à forte résolution.

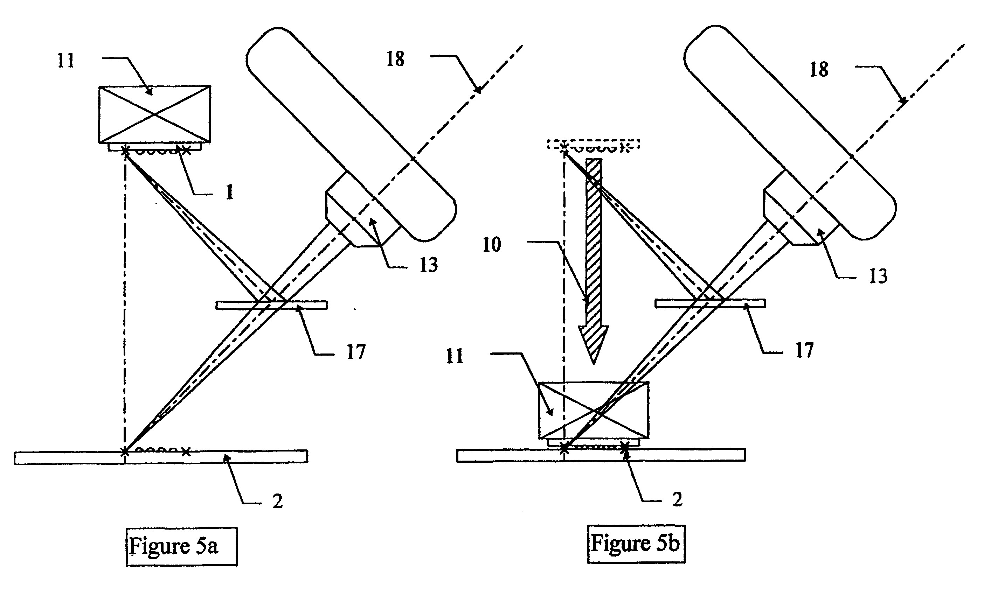

La figure 5a et la figure 5b illustrent une méthode utilisant un seul système de visée microscopique (13) et une lame semi réfléchissante (17) permettant de superposer les images du composant (1) et du substrat (2) lors de la phase d'alignement. Après alignement, un déplacement programmé (10) est appliqué au composant (1) par l'intermédiaire d'un dispositif mécanique (11) pour le déposer sur le substrat (2).

Cette méthode pose les problèmes techniques suivants :
■ La position finale du composant est sensible à l'épaisseur du composant, le système présentant un défaut de parallaxe ( non parallélisme de l'axe de visée (18) et de l'axe de dépose (10)).
■ Distance de visée importante, généralement incompatible avec l'utilisation de microscopes à forte résolution et à forts grandissements.
■ Visée du substrat (2) à travers une lame de verre semi réfléchissante (17) inclinée par rapport à l'axe moyen de visée (18). Cette configuration introduit des aberrations optiques telles que la coma et l'astigmatisme, ce qui réduit les capacités de résolution et de grandissement du système de visée.

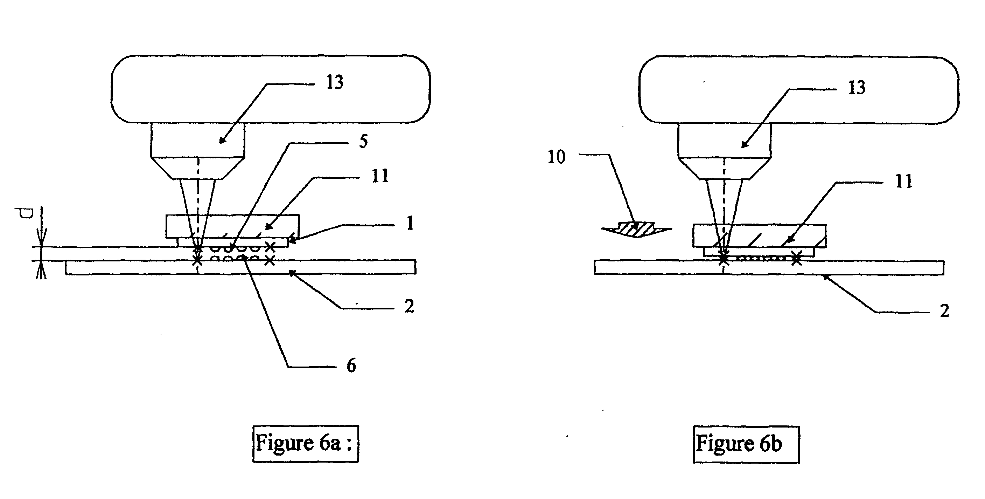

La figure 6a et la figure 6b illustrent une méthode applicable lorsque le composant (1) est transparent pour la longueur d'onde de lumière utilisée par le système de visée microscopique (13). La visée s'effectue à travers le support transparent (11) de composant (1). Lors de la phase d'alignement, le composant (1) et le substrat (2) sont séparés d'une distance (d) suffisante pour que les mouvements d'alignement puissent s'opérer sans que les plots (5) et (6) soient au contact l'un de l'autre. Après alignement, un déplacement programmé (10) est appliqué au composant (1) par l'intermédiaire d'un dispositif mécanique (11) pour le déposer sur le substrat (2).

Cette méthode pose les problèmes techniques suivants :
■ Le composant (1) doit être transparent, et ses deux faces doivent être parfaitement polies pour permettre la formation des images du substrat (2) et du composant (1)
■ Le composant étant généralement semi conducteur, il doit alors être fait appel à des systèmes de visée infrarouge.
■ La distance de séparation (d) nécessaire lors de la phase d'alignement empêche une mise au point parfaite du système de visée à la fois sur le composant (1) et sur le substrat (2)
■ Les métallisations présentes sur la face inférieure du composant (1) font écran et ne permettent pas la visualisation de la totalité de la surface du substrat (2).
■ Il est impossible d'illuminer différemment le composant (1) et le substrat (2).

le dispositif selon US 4 521 114, qui illustre l'arrière plan technologique, decrit un appareil qui ne donne pas entièrement satisfaction

Le dispositif d'alignement selon la revendication 1 permet de remédier à tous les inconvénients des méthodes citées précédemment.

### Figures et dessins

La figure 1a et la figure 1b illustrent le domaine technique de l'invention, à savoir le procédé d'assemblage de composants par la méthode de retournement de composant
Les figures 2a ; 2b ; 3a ; 3b ;4a ; 4b ; 5a ; 5b ;6a ;6b, illustrent l'état de la technique antérieure à l'invention.
La figure 7 schématise un système optique à obturation centrale
La figure 8 schématise un système optique sans obturation centrale
La figure 9 illustre le schéma optique de base de l'invention

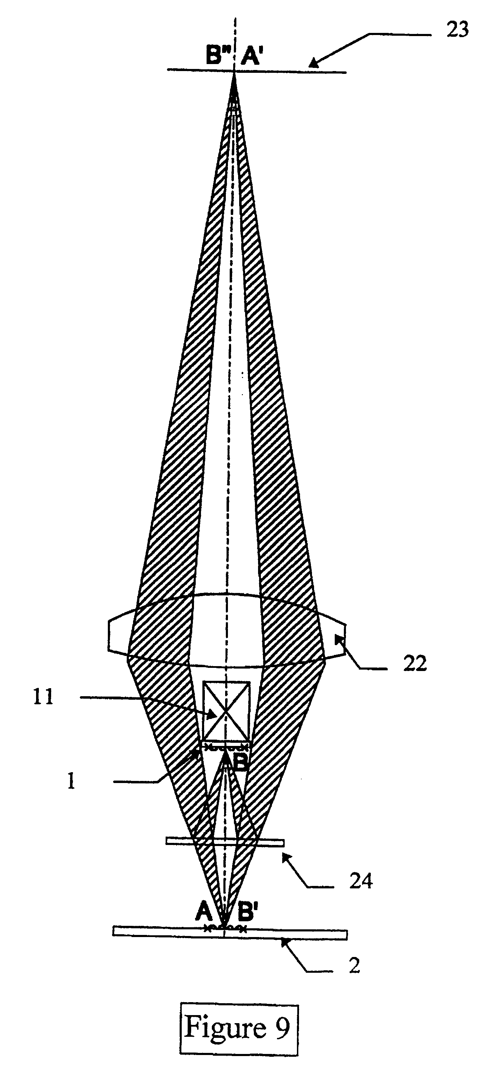

La figure 9 illustre le principe de base de l'invention

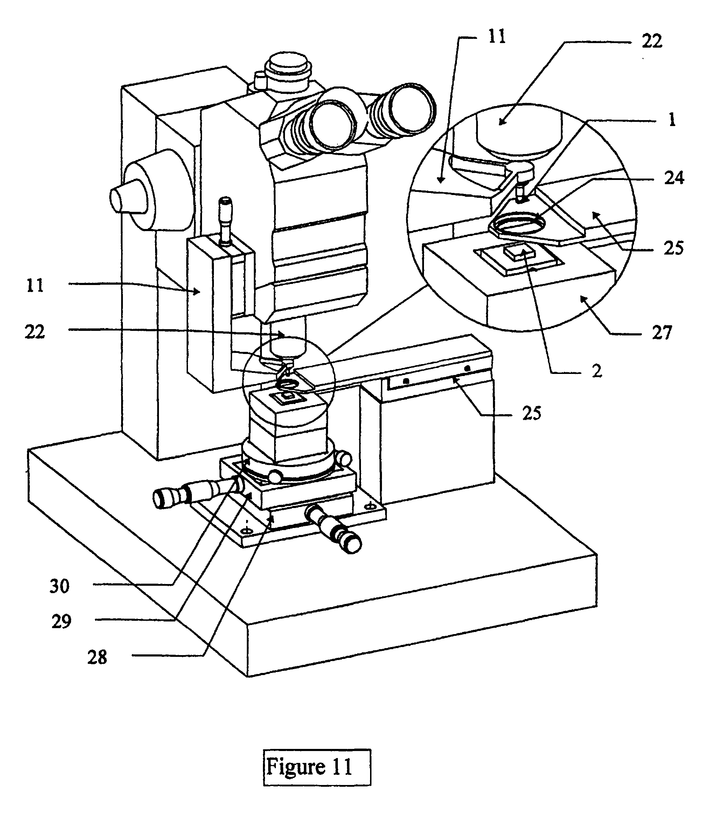

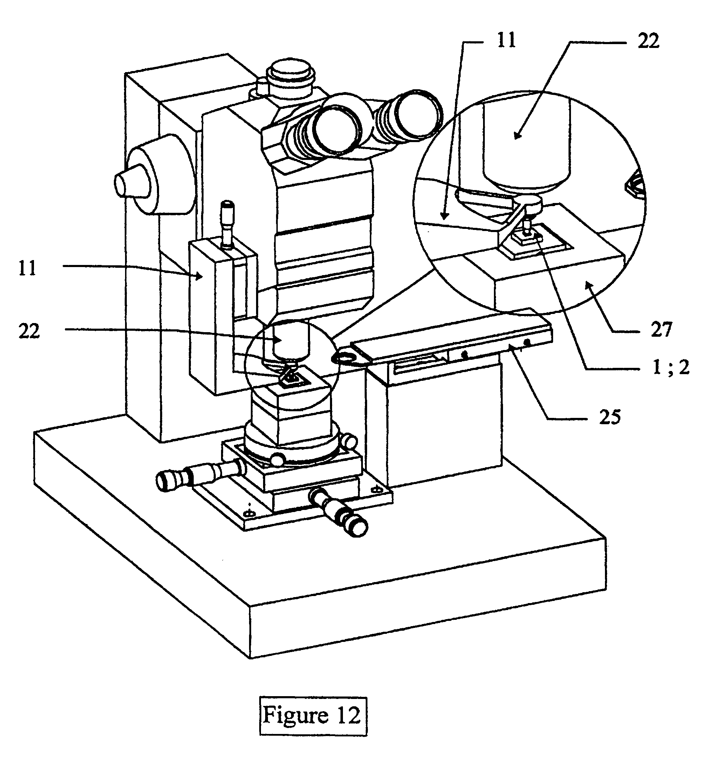

La figure 11 et la figure 12 illustrent un exemple de mode de réalisation de l'invention.

### Exposé de l'invention

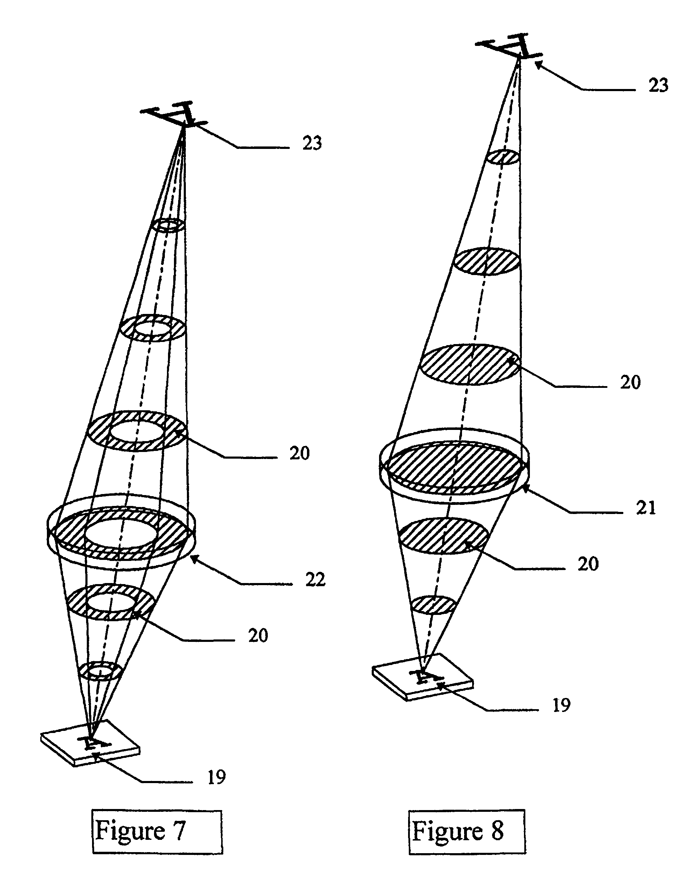

Le dispositif selon l'invention est principalement constitué d'un système de visée microscopique à obturation centrale (22), d'une lame semi réfléchissante plane (24) placée entre un composant et un substrat , et d'un dispositif mécanique (11) destiné au maintien et à la manipulation du composant (1). Un système optique à obturation centrale est caractérisé par le fait que les faisceaux lumineux émergents du point d'un objet constituent des cônes creux, alors que dans le cas d'un système optique traditionnel, ces faisceaux constituent des cônes pleins. La figure 8 représente un système optique sans obturation centrale. Les faisceaux lumineux issus des points de l'objet (19) ont des sections (20) pleines. Le système optique (21) forme une image (23) de cet objet dans son plan image. La figure 7 représente un système optique à obturation centrale. Les faisceaux lumineux issus des points de l'objet (19) ont des sections (20) annulaires. Le système optique (22) forme une image de cet objet dans son plan image (23). Aucun faisceau lumineux n'occupant le centre du système optique (22), le volume défini par l'intérieur du cône lumineux peut donc être occupé par divers éléments mécaniques. Cette particularité peut être mise à profit pour loger la partie terminale du dispositif (11) de maintien du composant (1).

La figure 9 représente le schéma optique du dispositif selon l'invention. Un composant (1) est maintenu au dessus d'un substrat (2) sur lequel il doit être déposé après avoir été aligné. Sur le dispositif (11) de maintien du composant, le composant peut être retenu par le vide (maintien par aspiration) les forces électrostatiques, le magnétisme, ou autres. Une lame plane et parallèle semi réfléchissante (24) est insérée entre le composant (1) et le substrat (2). La position de la lame (24) est réglée de telle manière que si on considère un point B du composant (1), la lame (24) va créer l'image virtuelle B' du point B confondue avec un point A du substrat (2) Ce réglage s'effectue, soit en déplaçant la lame (24), soit en déplaçant le dispositif mécanique (11). On observera dans le plan image (23) du système optique une image réelle A' de la face supérieure du substrat (2) superposée avec une image réelle B" de la face inférieure du composant (1). Dès lors, il est possible de visualiser en même temps les motifs (3) d'alignement du composant (1) et les motifs (4) d'alignement du substrat (2), et de corriger par les mouvements mécaniques appropriés la position de l'un par rapport à l'autre. A l'issue de cette phase d'alignement, la lame (24) est escamotée et le dispositif mécanique (11) dépose le composant (1) sur le substrat (2). Dans la mesure ou la surface de la lame (24) est parfaitement perpendiculaire à la trajectoire (10) de dépose du composant (1) sur le substrat (2), les écarts de position finale entre le composant (1) et le substrat (2) seront exactement ceux visualisés par le système optique (22). A titre d'exemple non limitatif, la visualisation des images peut se faire à l'aide d'un dispositif oculaire, d'une chambre photographique ou d'une caméra vidéo.

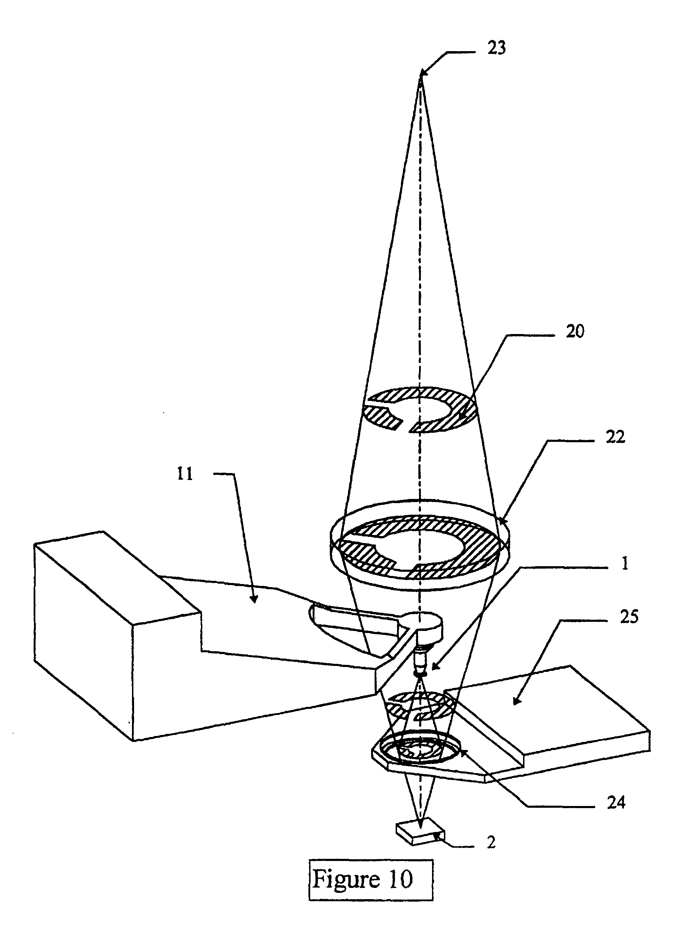

La figure 10 représente un possible agencement schématique du dispositif selon l'invention. L'obturation centrale du système optique (22) est provoquée par l'extrémité du dispositif (11) de maintien du composant (1). Dans ce cas, l'obturation centrale s'étend au delà du centre du système optique, selon plusieurs zones. Les sections (20) des faisceaux lumineux se présentent alors sous forme de secteurs d'anneaux.
Le dispositif décrit permet :
■ L'utilisation d'un seul système de visée microscopique pour l'alignement des deux composants. La lame plane (24) formant en B' une image au grandissement exactement unité de la surface inférieure du composant (1).
■ La dépose du composant (1) sur le substrat (2) sans avoir à déplacer le système de visée microscopique (22).
■ De minimiser la distance entre le composant (1) et le substrat (2) lors de la phase d'alignement des deux composants.
■ D'utiliser des dispositifs de visée (22) à forte ouverture numérique, compatibles avec de fortes résolutions et de forts grandissements, en conséquence de permettre d'assurer une grande précision de placement du composant (1) par rapport au substrat (2)
■ La visualisation de la surface inférieure du composant (1) et de la surface supérieure du substrat (2) sans effet de parallaxe.
■ L'alignement de composants non transparents.
■ D'utiliser un principe d'alignement relatif, ne nécessitant pas de précision absolue du déplacement (10) du dispositif (11) de maintien du composant (1) lors de la dépose de ce dernier sur le substrat (2)

### Exemple d'un mode de réalisation de l'invention

Les figures 11 et 12 représentent un mode de réalisation de l'invention, comportant un dispositif de visée (22), ( par exemple : microscope de mesure ), un dispositif (11) de maintien de composant (1), réglable par l'intermédiaire d'une table à déplacement micrométrique (26), une lame semi réfléchissante (24) et son dispositif d'escamotage (25); un substrat (2) et un dispositif d'alignement de substrat (27). Dans le cas représenté à titre d'exemple non limitatif, le dispositif d'alignement du substrat est constitué de deux tables à déplacements linéaires micrométriques croisées (28), (29) et d'une table micrométrique à déplacement angulaire autour d'un axe vertical (30). La figure 11 représente le dispositif lors de la phase d'alignement, la figure 12 représente le dispositif lors de la phase de dépose du composant. Le dispositif d'escamotage (25) de la lame semi réfléchissante (24) est retiré et le composant (1) est déposé sur le substrat (2).

### Applications industrielles

L'invention est susceptible d'être utilisée pour toute application nécessitant l'assemblage précis de dispositifs constitués de petits composants (taille de l'ordre de 0.2mm à 5mm), pour lesquels une grande précision de positionnement est requise (de l'ordre de 0.5µm à quelques µm). Une liste d'exemples d'applications, non limitative, est fournie ci-après :
■ Assemblage de composants micro électroniques.
■ Assemblage de diodes laser sur micro bancs silicium.
■ Assemblage de fibres optiques sur micro bancs silicium.
■ Assemblage de micro composants mécaniques.
■ Assemblage de modules micro opto électro mécaniques.
■ Assemblage de modules micro électro mécaniques
■ Assemblage et réalisation de modules micro biologiques.
■ Dépose précise de matériaux non solides, par exemple gouttelettes de colle ou de produits chimiques ou de cultures biologiques.

## Revendications

1. Dispositif d'alignement pour l'assemblage de microsystèmes électroniques, mécaniques, optiques, biologiques et hybrides, **caractérisé en ce qu'**il comporte un système de visée à obturation centrale (22), une lame plane parallèle (24) transparente pourvue sur l'une de ces faces d'un traitement semi réfléchissant, un dispositif mécanique (11) de maintien d'un composant (1), la lame (24) dont la normale est confondue avec l'axe optique du système de visée (22), formant sur la face supérieure d'un substrat (2) l'image virtuelle de la face inférieure du composant (1).

2. Dispositif selon la revendication 1 **caractérisé en ce que** l'obturation centrale du dispositif de visée (22) est constituée par tout ou partie du dispositif mécanique (11) de maintien du composant.

3. Dispositif selon la revendication 1 ou la revendication 2 en ce que l'obturation centrale du dispositif de visée (22) est constituée par une partie du dispositif de visée (22), notamment dans le cas de l'utilisation d'objectifs catadioptriques.

4. Dispositif selon l'une quelconque des revendications précédentes **caractérisé en ce que** l'obturation du dispositif de visée (22) s'étend au delà du centre de ce demier, selon une ou plusieurs zones.

5. Dispositif selon l'une quelconque des revendications précédentes **caractérisé en ce que** la lame semi réfléchissante (24) comporte un traitement dichroïque sur sa face réfléchissante, transmettant une partie du spectre lumineux utilisé par le système de visualisation pour la formation de l'image A' du substrat (2), réfléchissant une autre partie du spectre lumineux utilisé par le système de visualisation pour la formation de l'image B" du composant (1).

6. Dispositif selon l'une quelconque des revendications précédentes **caractérisé en ce que** la lame semi réfléchissante (24) comporte un trou en son centre, permettant au dispositif mécanique (11) de maintien du composant (1) de passer au travers de la lame semi réfléchissante (24) sans qu'il soit nécessaire de retirer la lame semi réfléchissante (24)

7. Dispositif selon l'une quelconque des revendications précédentes **caractérisé en ce que** le dispositif mécanique (11) de maintien de composant (1) est constitué par une partie du dispositif de visée (22).

8. Dispositif selon l'une quelconque des revendications précédentes **caractérisé en ce que** le dispositif mécanique (11) de maintien de composant (1) est pourvu de tous les degrés de liberté nécessaires au positionnement dans l'espace du composant (1)

9. Dispositif selon l'une quelconque des revendications précédentes **caractérisé en ce que** le mouvement (10) de dépose du composant (1) sur le substrat (2) est appliqué au substrat (2).

10. Dispositif selon l'une quelconque des revendications précédentes **caractérisé en ce que** le dispositif mécanique de maintien de composant est remplacé par un dispositif de micro distribution de matières non solides ( colles, produits chimiques, produits pharmaceutiques, produits radio actifs, produits biologiques, fragments d'A.D.N)

## Patentansprüche

1. Ausrichtvorrichtung für eine Montage von elektronischen, mechanischen, optischen, biologischen und hybriden Mikrosystemen, **dadurch gekennzeichnet, dass** sie eine Visiereinrichtung (22) mit einem Zentralverschluß, eine planparallele Platte (24), welche durchsichtig ist und an einer Seite eine halbreflektierende Beschichtung aufweist, eine Vorrichtung (11) zum Halten eines Bauteils (1) umfasst, die Platte (24), deren Normale mit der optischen Achse der Visiereinrichtung (22) zusammenfällt, auf der Oberseite einet Grundlage (2) das virtuelle Bild der Unterseite des Bauteils (1) abbildet.

2. Vorrichtung nach Anspruch 1, **dadurch gekennzeichnet, dass** der Zentralverschluß der Visiereinrichtung (22) ganz oder teilweise durch die mechanischen Vorrichtung (11) zum Halten des Bauteils gebildet wird.

3. Vorrichtung nach Anspruch 1 oder 2, **dadurch gekennzeichnet, dass** der Zentralverschluß der Visiereinrichtung (22) insbesondere bei der Verwendung von Spiegellinsenobjektiven durch einen Teil der Visiereinrichtung (22) gebildet wird.

4. Vorrichtung nach einem der vorstehenden Ansprüche, **dadurch gekennzeichnet, dass** der Verschluß der Visiereinrichtung (22) sich über die Mitte derselben hinaus in einem oder mehreren Bereichen erstreckt.

5. Vorrichtung nach einem der vorstehenden Ansprüche, **dadurch gekennzeichnet, dass** die halbreflektierende Platte (24) auf ihrer reflektierenden Seite eine dichroitische Beschichtung aufweist, die einen Teil des Lichtspektrums, der von der Anzeigevorrichtung zur Abbildung des Bilds A' der Grundlage (2) verwendet wird, weiterleitet, während sie einen anderen Teil des Lichtspektrums, der von der Anzeigevorrichtung zur Abbildung des Bilds B" des Bauteils (1) verwendet wird, reflektiert.

6. Vorrichtung nach einem der vorstehenden Ansprüche, **dadurch gekennzeichnet, dass** die halbreflektierende Platte (24) in ihrer Mitte ein Loch aufweist, über welches die mechanische Vorrichtung (11) zum Halten des Bauteils (1) durch die halbreflektierende Platte (24) hindurchgeführt werden kann, ohne diese halbreflektierende Platte (24) entfernen zu müssen.

7. Vorrichtung nach einem der vorstehenden Ansprüche, **dadurch gekennzeichnet, dass** die mechanische Vorrichtung (11) zum Halten des Bauteils (1) als Teil der Visiereinrichtung (22) ausgebildet ist.

8. Vorrichtung nach einem der vorstehenden Ansprüche, **dadurch gekennzeichnet, dass** die mechanische Vorrichtung (11) zum Halten des Bauteils (1) alle Freiheitsgrade aufweist, die zur räumlichen Positionierung des Bauteils (1) erforderlich sind.

9. Vorrichtung nach einem der vorstehenden Ansprüche, **dadurch gekennzeichnet, dass** die Bewegung (10), mit der das Bauteil (1) auf der Grundlage (2) abgelegt wird, auf die Grundlage (2) aufgebracht wird.

10. Vorrichtung nach einem der vorstehenden Ansprüche, **dadurch gekennzeichnet, dass** die mechanische Vorrichtung zum Halten des Bauteils durch eine Vorrichtung zur Mikroverteilung von nicht festen Substanzen (von Klebstoffen, chemischen Produkten, pharmazeutischen Produkten, radioaktiven Produkten, biologischen Produkten, DNA-Bruchstücken) ersetzt wird.

## Claims

1. Alignment device for the assembly of electronic, mechanical, optical, biological and hybrid microsystems, **characterised in that** it has a sighting system with central obturation (22), a transparent plane-parallel plate (24) provided on one of these faces with a semi-reflective treatment, a mechanical device (11) for holding a component (1), the plate (24), whose normal coincides with the optical axis of the sighting system (22), forming the virtual image of the lower face of the component (1) on the upper face of a substrate (2).

2. Device according to Claim 1, **characterised in that** the central obturation of the sighting device (22) consists of all or some of the mechanical device (11) for holding the component.

3. Device according to Claim 1 or Claim 2, in that the central obturation of the sighting device (22) consists of a part of the sighting device (22), in particular in the case of using catadioptric objectives.

4. Device according to any one of the preceding claims, **characterised in that** the obturation of the sighting device (22) extends beyond the centre of the latter, over one or more zones.

5. Device according to any one of the preceding claims, **characterised in that** the semi-reflective plate (24) has a dichroic treatment on its reflective face, transmitting a part of the light spectrum used by the visualisation system for forming the image A' of the substrate (2), reflecting another part of the light spectrum used by the visualisation system for forming the image B'' of the component (1).

6. Device according to any one of the preceding claims, **characterised in that** the semi-reflective plate (24) has a hole at its centre, allowing the mechanical device (11) for holding the component (1) to pass through the semi-reflective plate (24) without it being necessary to withdraw the semi-reflective plate (24).

7. Device according to any one of the preceding claims, **characterised in that** the mechanical device (11) for holding the component (1) consists of a part of the sighting device (22).

8. Device according to any one of the preceding claims, **characterised in that** the mechanical device (11) for holding the component (1) is provided with all the degrees of freedom necessary for positioning the component (1) in space.

9. Device according to any one of the preceding claims, **characterised in that** the movement (10) for depositing the component (1) on the substrate (2) is applied to the 5 substrate (2).

10. Device according to any one of the preceding claims, **characterised in that** the mechanical device for holding the component is replaced by a device for micro-dispensing of non-solid materials (adhesives, chemical products, pharmaceutical products, radioactive products, biological products, DNA fragments).
